# EUROPEAN PATENT APPLICATION

(11) **EP 0 834 391 A1**
(43) Date of publication of application: **08.04.1998**
(21) Application number: 96907683.5
(22) Date of filing: 28.03.1996
(51) Int. Cl.: B29C 69/00, H05K 3/38, C25D 5/56

(54) **PROCESS FOR PRODUCING RESIN MOLDING HAVING MINUTE CAVITIES ON THE SURFACE**

(30) Priority: 18.04.1995 JP 92279/95
(71) Applicant: National Starch and Chemical Investment Holding Corporation, Wilmington, Delaware 19809 (US)
(72) Inventor: KINASHI, Keiichi, Ebina-shi, Kanagawa-ken 243-04 (JP); CHIBA, Reiko, Atsugi-shi, Kanagawa-ken 243-02 (JP); HAGIWARA, Yoshichi, Atsugi-shi, Kanagawa-ken 243-02 (JP)
(74) Representative: Daniels, Jeffrey Nicholas
(86) International application number: JP9600817
(87) International publication number: WO9633065

(57) **Abstract**

The purpose of the present invention is to provide a method which is suitable for roughing the surface of a resin form, particularly a method suitable for certainly roughening the surface of an interlayer insulating resin for a multilayer printed circuit board to be prepared by a "build-up" method.

The process of the present invention comprises molding a mixture comprising chemical-soluble powder formulated in a resin composition, treating the surface layer of thus obtained resin form with a chemical solution that can dissolve the resin to remove the surface layer of the resin and to expose on the surface of the form at least a part of the powder contained in the form, and subsequently treating the surface with a chemical solution that can dissolve the powder to remove the powder exposed on the surface.

## Description

### FIELD OF THE INVENTION

This invention relates to a process of forming micro-recesses on the surface of a substrate, in order to increase the bonding force of the plating metal on the substrate relating mainly to the production of a printed circuit board that carries electrical and electronic parts. The process of this invention is used advantageously, particularly for forming micro-recesses on the surface of the photosensitive insulating resin layer in the preparation of a multilayer printed circuit board by a "build-up" method.

### BACKGROUND OF THE INVENTION

In the conventional method of preparing a multilayer circuit board, firstly, prepregs were sandwiched between substrates on each of which a copper wiring pattern was formed, and then through-holes are formed at prescribed locations, the interior of the through-holes was copper-plated, and the wiring patterns in each substrates were then connected. However, in the above-said production process, since a press machine employed is large and expensive, the production process is complicated, and it is required to control the process more precisely, it has been difficult to reduce the cost.

On the other hand, a production process of a multilayer printed circuit board by the so-called "build-up" process is attracting attention, in which a plating is applied on an insulating resin layer to form a copper wiring pattern layer, then another insulating resin is coated over that layer, and the steps are repeated. To explain this method explicitly, first a substrate having a copper wiring pattern is provided as a base, and an insulating resin is printed on the base by using a screen coater on a curtain coater to form an insulating resin layer, and then another copper wiring pattern is formed on this insulating resin layer by a subtractive method or an additive method, to thereby the second copper wiring pattern. Specifically, in the case of using the subtractive method, a copper plating is applied on the insulating resin layer, and then an etching resist is coated pattern-wise so that the required copper circuit part is formed, and then the copper in the uncoated area is chemically removed, to form a pattern and to obtain the second layer of copper writing pattern. In the additive method, a second layer of copper wiring pattern is obtained by plating copper directly on the insulating resin by using a patterning plating resist to form a pattern. These steps are repeated several times so as to form multilayers of copper wiring patterns, and the wiring patterns in each substrate are then electrically connected via pier holes and through-holes, to obtain a multilayer circuit board.

The insulating resins to be used in this process have mainly been photosensitive resins that are suitable for high density packaging. The build-up method, compared to the conventional production method of a multilayer wiring board, can be used for high density wiring and for reducing the thickness and size of the substrate. In addition, it can drastically reduce costs, because it does not require a press machine. However, in the build-up method, since a copper wiring pattern is applied on a cured insulating resin layer, as compared to the conventional method in which a resin prepreg is molten and pressed onto the roughed copper foil, recesses must be formed on the insulating resin layer in order to create sufficient bonding force between the insulating resin and the copper. A variety of methods for forming recesses on the insulating resin layer have been investigated. For example, a method of grinding the surface of the insulating resin layer with a brush or sand paper, etc. to roughen the surface is available. However, this still can not create a sufficient "anchoring effect" and therefore a satisfactory bonding force can not be created. Another method is to form a resin layer using a thermosetting resin composition such as a phenol resin containing butadiene rubber and the like admixed thereto, and then to form recesses on the surface of the insulating resin layer by treating the resin layer with an oxidizing agent such as potassium permanganate or chromic acid to remove the rubber component. Although this method may improve the bondability of the copper with the insulating resin, it tends to lower the reliability of the insulating resin such as solder heat resistance and electrical properties, etc, because the polybutadiene rubber has poor heat resistance and contains many ionic impurities. To overcome this problem, there exists a method of mixing inorganic or organic particles which do not lower the solder resistance or electrical properties in the resin, in place of the rubber components. However, since the chemical solution which dissolves a resin generally can not easily to dissolve such inorganic or organic particles, treatment of the resin layer with such a resin-dissolving chemical solution alone may dissolve only fine particles which comprise a minor portion of the entire particles and the resin on the surface, and many undissolved particles will remain, only a portion of which are exposed on the surface of the resin. Therefore, effective recesses can not be formed on the surface of the resin layer by this method.

### DETAILED DESCRIPTION

As a result of extensive investigation to solve the above-mentioned problems, the inventors have discovered that recesses can be formed properly on the surface of a resin form by adding a chemical-soluble powder to a resin composition and then molding the mixture, thereafter dissolving the surface layer of this resin form to expose a part of the powder on the surface, and then dissolving and removing the powder. Based on this discovery, the present inventors finally accomplished this invention.

According to the method of this invention, the surface layer of the resin form is first dissolved with a chemical solution that can dissolve the resin to expose on the surface of the form at least a part of the powder contained in the form, by which the powder on the surface can be easily removed, and subsequently treating the surface with a chemical solution that can dissolve the powder and remove the powder exposed on the surface. According to such a method, the powder can be removed more quickly than by the conventional method in which the powder removal was insufficient, and recesses can be formed successfully on the surface of the resin.

The scope of application of the method of this invention is not limited. However, this method may preferably be applied to a roughing of the surface of a photosensitive interlayer insulating resin in the production of a multilayer printed circuit board by a build-up method. Therefore, for convenience, an embodiment of the method of this invention for roughing the surface of a photosensitive interlayer insulating resin in the production of a multilayer printed circuit board by a build-up method, is explained below. However, the term "resin form" used in this specification and particularly in the claims, includes a coating layer obtained by coating the resin on the surface of a substrate, etc. as well as a structural member obtained by an injection molding process of the resin. Those skilled in the art will easily understand that the method of this invention can be applied to any situation where roughing of a surface of a resin form is required, such as in the case of applying a metal plating to the surface of a resin form.

Thus, the first embodiment of this invention relates to a process for preparing a resin form having micro-recesses on the surface thereof which comprises molding a mixture comprising a chemical-soluble powder formulated in a resin composition, treating the surface layer of the thus obtained resin form with a chemical solution that can dissolve the resin to remove the surface layer of the resin and to expose on the surface of the form at least a part of the powder contained in the form, and subsequently treating the surface with a chemical solution that can dissolve the powder and remove the powder exposed on the surface. The second preferred embodiment of this invention relates to a process of preparing a multilayer circuit board which comprises applying a photosensitive insulating resin composition containing a chemical-soluble powder added thereto on a substrate on which a metallic circuit pattern is formed, to thereby form a resin coating layer; dissolving and removing the surface layer of the resin coating by using a chemical solution which dissolves the resin, to expose at least a part of the powder on the surface of the resin coating layer; and subsequently treating the surface with a chemical solution which dissolves the powder to dissolve and remove the powder exposed on the surface, to thereby form micro-recesses on the surface of the resin coating layer; and then forming a circuit pattern on the resin coating layer by metal plating using an additive method or a subtractive method; and repeating the process for a predetermined time.

Constitution of this invention is explained in the following, using the second preferred embodiment of this invention, as an example. In the method according to the preferred embodiment of this invention, the method can be applied on either a liquid or film photosensitive resin which is to be used as the resin layer. However, liquid resin is preferred from the viewpoint of economy. In the case of using a liquid photosensitive resin, the resin may or may not contain a solvent. However, since the solvent-free liquid resin will require special equipment in the subsequent exposure process, it is more desirable to use a liquid resin containing a solvent which provides a less tacky surface after drying.

A powder which can be dissolved by a chemical solution is pre-mixed in the resin composition containing the above-mentioned resin to provide a resin mixture, and this mixture is then coated on a substrate (underlayer) to obtain a resin layer.

Thereafter, the surface of the resin layer is first treated with a chemical solution that can dissolve the resin to dissolve and remove the resin in the surface layer, thereby to expose at least a part of the powder mixed in the resin on the surface of the resin layer. As an alternative method for exposing the powder on the surface of the layer, a method of polishing and thereby removing the surface of the resin using a brush or sandpaper is available, but such a method is not effective since the powder can not be exposed sufficiently thereby. Subsequently, the thus-treated surface of the resin layer is treated with a chemical solution that can dissolve the powder, to thereby completely dissolve and remove the powder which has been exposed on the surface of the resin layer, whereby recesses are provided on the surface of the resin layer. Roughing the surface of the resin layer by the above-described procedure may be carried out at any stage, such as after drying the resin layer, after exposure thereof, or after post-curing thereof. However, it is generally desirable to carry out the roughing step after post-curing of the resin layer, in order to reduce the defects or modification of the insulating resin layer caused by the chemical solution.

The photosensitive insulating resin that can be used in the preferred embodiment of this invention, is not particularly limited and includes, for example, an epoxy resin, a polyimide resin and diallyl phthalates. Examples of the epoxy resin may include, for example, unsaturated epoxy esters obtained by reacting a part or the entire epoxy groups of glycidyl ether type epoxies or alicyclic type epoxies such as bisphenol-A type, phenol Novolak type, or cresol Novolak type, with a monocarboxylic acid having an ethylenic unsaturated group, or carboxylated unsaturated epoxy esters obtained by further reacting the epoxy esters with an acid anhydride. Among these resins, carboxylated unsaturated epoxy esters which can be developed with an aqueous alkaline developer are preferred for environmental and safety reasons.

Among those resins described above, the epoxy resins, the polyimide resins and the diallyl phthalate are used generally together with a photoradical polymerization initiator. Or, the glycidyl ether type epoxy resins or alicyclic epoxy resins may also be used together with a photocationic polymerization initiator. Further, the above-said photosensitive insulating resins may be used together with thermosetting epoxy resins and a curative, and may be thermally cured after photo-curing with UV light. Examples of the curative that can be used when the photosensitive insulating resin is used together with the thermosetting resins such as epoxy resin, may include imidazoles such as 2-methylimidazole, 2-phenyl-4-methylimidazole, dicyan diamide, amines such as melamine, acetoguanamine, and adipic dihydrazide and the like.

Examples of the photocationic polymerization initiator that can be used to photocure the glycidyl ether type epoxy resins or alicyclic epoxy resins include triallylsulfonium hexafluoro antimonate, triallylsulfonium hexafluorophosphate and the like, and these compounds may be used alone or in combination. The amount of the photocationic polymerization initiator to be added is 1 weight % - 20 weight % based on the weight of the photosensitive resin. In order to improve the reactivity and curability of the resin with the photocationic polymerization initiator, a polyol type curative such as ε-caprolactone triol and the like may be used together. From the viewpoint of curability, preferred amount is such that an epoxy group/alcoholic hydroxy group ratio of 1-10 is provided.

In the case of using an unsaturated epoxy ester, a carboxylated unsaturated epoxy ester, a photosensitive polyimide resin or a diallyl phthalate together with the photopolymerization initiator, a photopolymerizable monomer may be added further. Appropriate amount to be added of the monomer is no more than 50 weight % of the photosensitive resin. Examples of the photopolymerizable monomers that can be used include 2-hydroxyethyl acrylate, 2-hydroxypropyl acrylate, N-vinylpyrrolidone, acryloyl morpholine, methoxytetraethylene glycol acrylate, methoxypolyethylene glycol acrylate, polyethylene glycol diacrylate, N,N-dimethyl acrylamide, N-methylol acrylamide, N,N-dimethylaminopropyl acrylamide, N,N-dimethylaminoethyl acrylate, melamine acrylate, diethylene glycol diacrylate, triethyleneglycol diacrylate, propyleneglycol diacrylate, dipropyleneglycol diacrylate, tripropyleneglycol diacrylate, polypropyleneglycol diacrylate, phenoxyethyl acrylate, tetrahydrofurfuryl acrylate, cyclohexyl acrylate, trimethylolpropane triacrylate, glycerin diglycidylether diacrylate, pentaerythritol triacrylate, pentaerythritol tetracrylate, pentaerythritol pentacrylate, pentaerythritol hexacrylate, dipentaerythritol pentacrylate, dipentaerythritol hexacrylate, and the corresponding methacrylates thereof, which may be used alone or in combination. Examples of the photopolymerization initiator that can be used in this invention include quinones such as 2-ethyl anthraquinone, 2-butyl anthraquinone, octamethyl anthraquinone; α-ketaldonyl alcohols or ethers such as benzoin, pivaloin or acyloin ether; and ketones such as α-phenyl benzoin, α,α'-diethoxy acetophenone, benzophenone, α,α'-dimethoxy-α-morpholino-methylthiophenyl acetophenone, benzophenone, α,α'-dimethoxy-α-morpholino-methylthiophenyl acetophenone, diethyl thioxanthone. These compounds may be used alone or in combination. The amount to be used thereof is 1-50 parts by weight, preferably 2-20 parts by weight based on the amount of the photosensitive unsaturated ester resin.

An organic powder or inorganic powder can be used as the powder in this invention, as long as it is soluble in the chemical solution to be used for dissolving it. However, particularly if application of the form in a multilayer printed circuit board is taken into consideration, those powders which lower the heat resistance, moisture resistance or electrical properties are not desirable. Therefore, the examples of the inorganic powder include barium sulfate, calcium carbonate, silica, and aluminum hydroxide, etc. The examples of the organic powder include silicone rubber, silicone resin, and polymethyl methacrylate, etc. These powders may be used alone or in combination of two or more thereof. The preferred particle size of the organic or inorganic powder to be used is 0.01-100 µm. If it is smaller than 0.1 µm, degree of roughing will be too low and it can not provide sufficient bondability of the resin layer with a metal such as copper. On the other hand, if the particle size exceeds 100 µm, it may interfere with the formation of delicate circuits. The preferred amount of the powder to be added is 5-100 parts by weight per 100 parts by weight of the solid of the resin. If it is less than 5 parts by weight, density of the recesses formed on the resin will be too low and a resulting roughness will not be sufficient. On the other hand, if it exceeds 100 parts by weight, viscosity of the resin will be too high, which may cause a decrease in coatability of the resin on the substrate. Incidentally, a small amount of inorganic fine powder having a diameter of not more than 0.1 µm may be added to provide thixotropic properties to the resin.

A coloring agent such as a phthalocyanin green, titanium oxide, or a carbon black, an antifoam agent such as a silicone oil, a leveling agent, an adhesion promoter, and a UV absorber, etc. may be added to the photosensitive composition, as needed. Furthermore, various known inorganic fillers may be added to the composition to improve mechanical or electrical properties thereof.

The liquid photosensitive insulating resins which are preferably used in the method of the preferred embodiment of this invention can be applied on the substrate which serves as the underlayer, by means of a curtain coater or a screen coater, etc. In this case, an organic solvent can be used as a diluent to regulate the viscosity of a photosensitive insulating resin. Specific examples of the organic solvent include glycols such as diethyleneglycol monoethylether, diethyleneglycol monomethylether, ethyleneglycol monoethylether, ethyleneglycol monomethylether, ethyleneglycol monobutylether; diethyleneglycol monoethylether acetate, diethyleneglycol monomethylether acetate, ethyleneglycol monoethylether acetate, ethyleneglycol monomethylether acetate, ethyleneglycol monobutylether acetate. A naphtha such as dimethylbenzene or dimethylbenzene, etc. can be used also. These compounds may be used alone or in combination.

There is no particular limitation about the type of the chemical solution that can be used to dissolve the resin, and thus various types of chemical solutions can be used for respective resins. However, from the viewpoint of solubility, an oxidizing aqueous solution of, for example, permanganate or chromic acid, etc. are the most favorable. For example, if an unsaturated epoxy ester is used as the resin, an aqueous permanganate solution can be used as the chemical solution to dissolve the resin.

If barium sulfate, calcium carbonate, silicone rubber, or silicone resin is used as the powder, an inorganic acid such as sulfuric acid or hydrochloric acid, etc. can be preferably used as the chemical solution to dissolve the powder in the resins to properly form recesses on the surface of resin layers. If silica or aluminum hydroxide is used as the powder, an aqueous alkali solution such as a caustic soda or a caustic potash can be used. If a polymethyl methacrylate is used as the powder, an organic solvent can be preferably used to dissolve the powder. Among the above-mentioned powder and chemical solution, the most preferred is a combination in which barium sulfate, calcium carbonate, silicone rubber or silicone resin is used alone or in combination as the powder, and an inorganic acid such as sulfuric acid or hydrochloric acid is used as the chemical solution, since recesses can be certainly formed even by treatment with the chemical solution at room temperature in a short period of time.

Treatment of the surface layer of the resin and powder with a chemical solution can be carried out at any stage, such as after drying the resin, after exposure to light, or after the post-curing process. However, it is generally most desirable to conduct such a treatment after the post-curing of the resin layer because it reduces the defects or modification of the insulating resin layer caused by the chemical solution.

We have explained an embodiment of using this invention for formation of micro recesses on the surface of a photosensitive interlayer insulating resin in production of a multilayer printed circuit board, particularly by a build-up method. However, it is apparent to those skilled in the art that the method of this invention is not limited to the above mentioned embodiment but can be used for any applications that require formation of micro recesses on the surface of a resin form. For example, beside the photosensitive resins which are used favorably in the first embodiment of this invention, resins such as polyester, etc. can be used in the application on electrical parts, automobile parts, and machine parts, etc. In such cases, an aqueous solution such as a caustic soda or a caustic potash solution can be used as the chemical solution, and an inorganic powder such as a silica or titanium oxide can be used as the powder, and an aqueous solution such as a caustic soda or a caustic potash solution can be used as the chemical solution to remove the powder.

### INDUSTRIAL APPLICABILITY

Thus, this invention provides a suitable method for roughing the surface of a resin form, particularly a method for certainly roughing the surface of an interlayer insulating resins in preparation of a multilayer printed circuit boards by a build-up method.

### EXAMPLES

Preferred embodiments of this invention are explained below by way of the following Examples of Synthesis, Comparative Examples and Working Examples which, however, are not intended to limit the scope of this invention.

### SYNTHESIS OF UNSATURATED EPOXY ESTER AND CARBOXYLATED UNSATURATED EPOXY ESTER

### EXAMPLE OF SYNTHESIS 1

A method described in Japanese Patent Kokai HEI 05-320312 (1993) was employed as the basic synthetic procedure.

180 g of a phenol Novolak type epoxy resin EPPN-201 (a product of Nippon Kayaku K.K., epoxy equivalent=180, average molecular weight=1300) was dissolved in 155 g of diethyleneglycol monoethylether acetate, and 0.05 g of hydroquinone, 39.6 g (0.55 mol) of acrylic acid and 2.27 g of triphenyl phosphine were added as the polymerization inhibitor. Acrylation reaction was carried out at 90°C while bubbling air. The point at which the acid value reached nearly 0 when the reaction mixture was titrated with alcoholic potassium hydroxide solution using phenolphthalein as the indicator was determined as the end point of the reaction. A pale brown liquid product (376.92 g) was obtained (yield 100%). IR analysis of the product showed a peak at 1739 cm⁻¹ attributed to the C=O absorption of ester group. The concentration of the epoxy group remained in the product was measured according to the procedure specified in JIS 7236-1986, to find to be 0.45 Mol. Subsequently, 1.97 g of cumene hydroperoxide was added, and triphenyl phosphine was oxidized and thereby inactivated at 90°C for 6 hours. 378.89 g of a pale brown liquid product was obtained (yield = 100%).

### EXAMPLE OF SYNTHESIS 2

To 378.89 g of the unsaturated epoxy ester obtained in EXAMPLE OF SYNTHESIS 1, added was 53.9 g (0.35 mol) of hexahydrophthalic anhydride, and carboxylation reaction was conducted at 40°C. 432.79 g of a brown liquid carboxylated unsaturated epoxy ester product was obtained (yield = 100%).

### EXAMPLES 1-5 AND COMPARATIVE EXAMPLES 1 AND 2

To 60 g of the resin obtained in the EXAMPLE OF SYNTHESIS 1, 4 g of a photopolymerization initiator IC-907 (a product of Ciba-Geigy Co.), 0.4 g of diethyl thioxanthone (a product of Nippon Kayaku K.K.), 4 g of dipentaerythritol hexacrylate (a product of Toa Gosei K.K.) as the acrylic monomer, 1 g of a melamine curative (a product of Nissan Kagaku K.K.), and 12 g of a silicone resin powder (TOSPEARL 240, a product of Toshiba Silicone K.K.) were added and mixed thoroughly. The thus-obtained photosensitive resin composition was applied to a thickness of 80 mm on a glass epoxy substrate by a screen coating method, and then dried at 80°C for 20 minutes to remove the solvent. Subsequently, the photosensitive resin composition was exposed to UV light (500 mJ/cm²), and then thermally cured at 150°C for 1 hour. The thus-obtained sample was treated with alkaline permanganate (40g-NaOH, 50g-KMnO₄/1000cc-water) at 70°C for 30 minutes, to dissolve the resin surface layer. Thereafter, the silicone resin powder exposed on the surface of the resin layer was treated with a 95% sulfuric acid solution at 25°C for 2 minutes, to thereby rough the surface. Examination of the surface by a scanning electron microscopy (SEM) revealed formation of uniform recesses on the surface of the resin layer resulted from dissolution of the powder.

Powder was mixed with the photosensitive insulating resin shown in Table 1 according to the same procedure, and the surface after roughing was examined by SEM. In Examples 2-5, uniform recesses were observed as in Example 1. On the other hand, no recesses were observed in Comparative Examples 1 and 2.

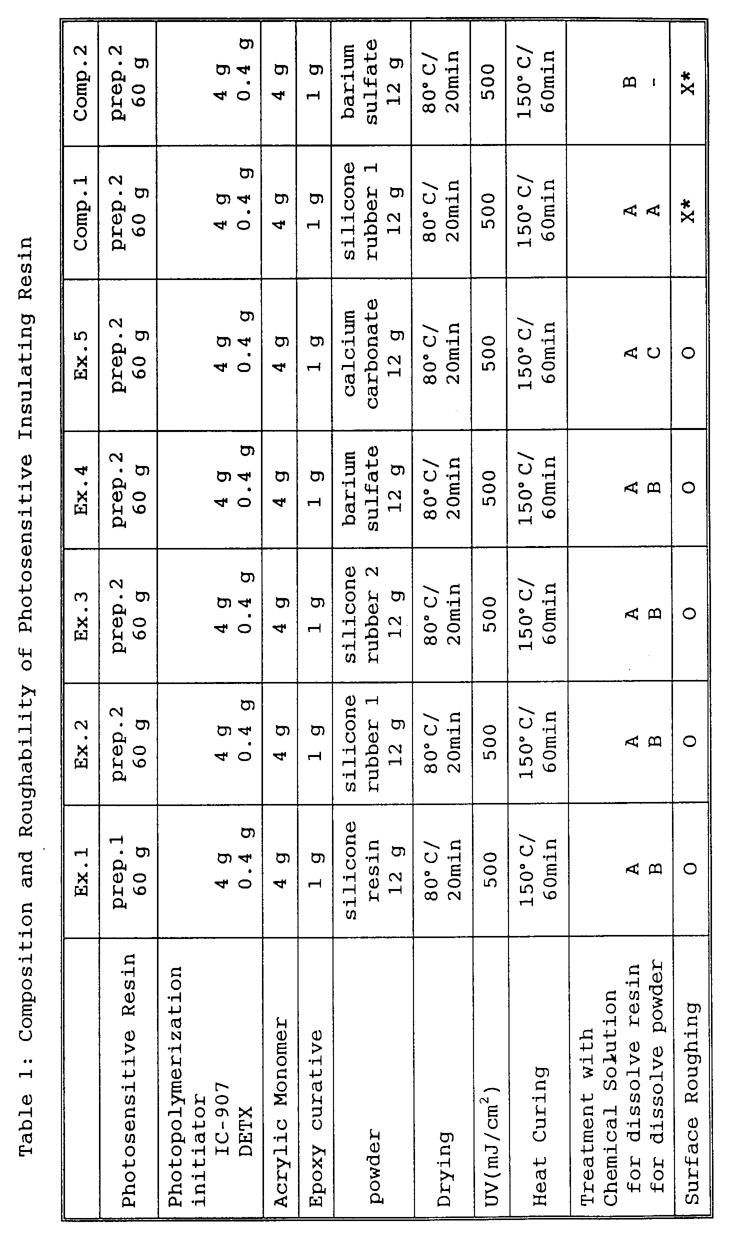

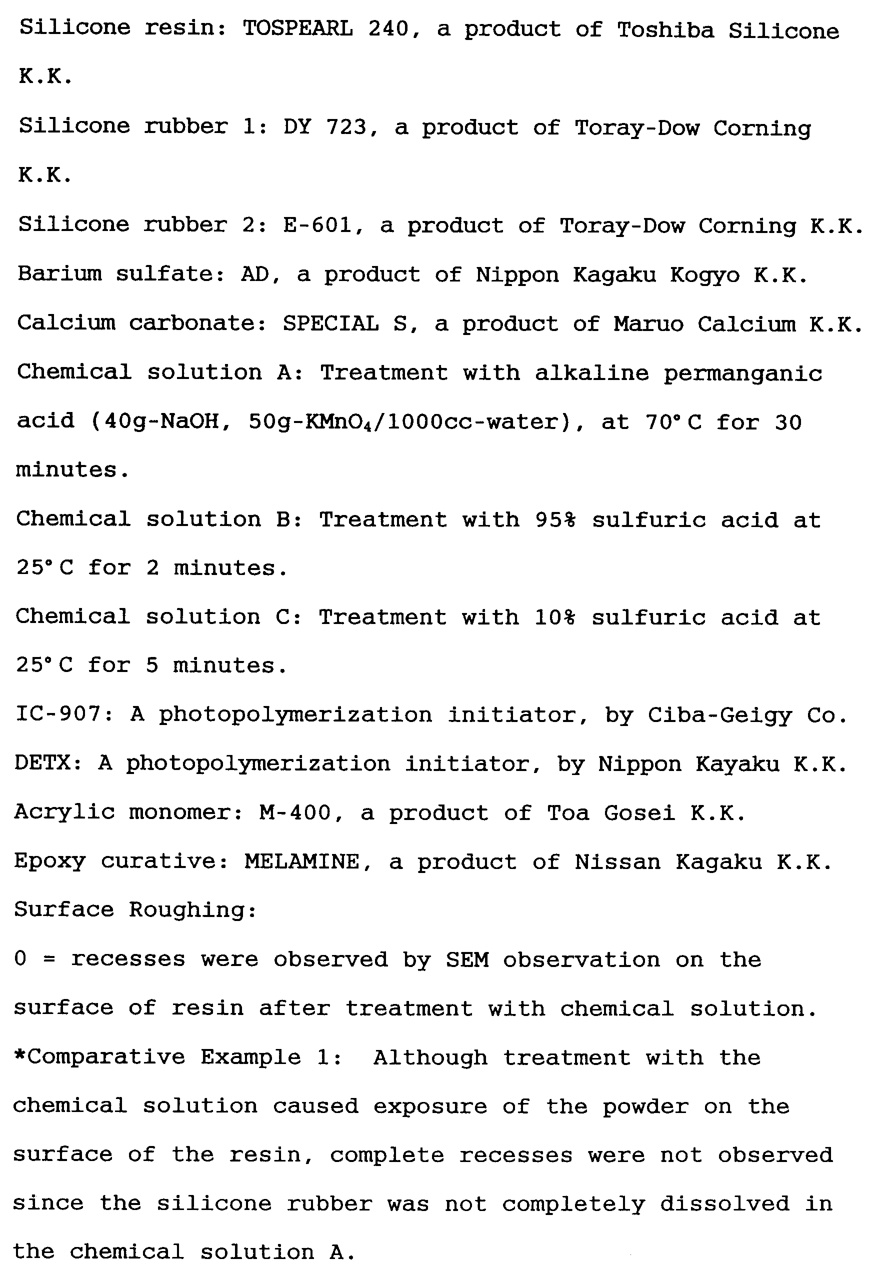

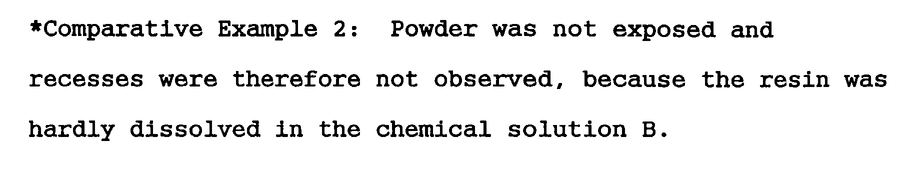

## Claims

1. A process for preparing a resin form having micro-recesses on the surface thereof which comprises molding a mixture comprising a chemical-soluble powder formulated in a resin composition, treating the surface layer of the thus obtained resin form with a chemical solution that can dissolve the resin to remove the surface layer of the resin and to expose on the surface of the form at least a part of the powder contained in the form, and subsequently treating the surface with a chemical solution that can dissolve the powder to remove the powder exposed on the surface.

2. A process of preparing a multilayer circuit board which comprises applying a photosensitive insulating resin composition containing a chemical-soluble powder added thereto on a substrate on which a metallic circuit pattern is formed, to form a resin coating layer; dissolving and removing the surface layer of the resin coating by using a chemical solution which dissolves the resin, to expose at least a part of the powder on the surface of the resin coating layer; and subsequently treating the surface with a chemical solution which dissolves the powder to remove the powder exposed on the surface, to thereby form micro-recesses on the surface of the resin coating layer; and then forming a circuit pattern on the resin coating layer by metal plating using an additive method or a subtractive method; and repeating the process for a predetermined time.

3. The process according to Claim 2, wherein the photosensitive insulating resin is a photosensitive resin solution which, when dried, will give a non-tacky surface.

4. The process according to Claim 2, wherein the photosensitive insulating resin is developable with an aqueous alkali solution.

5. The process according to Claim 2, wherein the chemical-soluble powder is an organic or inorganic powder having an average particle size of 0.10-100 µm and soluble in neutral water, acidic water, alkaline water or an aqueous solution of oxidizing compound.

6. The process according to Claim 2, wherein the chemical solution which dissolves the insulating resin is an oxidizing chemical solution.

7. The process according to any of Claims 2-6, wherein the chemical-soluble powder is a powder soluble in an acid and the chemical solution which dissolves the powder is the acid.
